# EUROPEAN PATENT APPLICATION

(11) **EP 1 538 679 A1**
(43) Date of publication of application: **08.06.2005**
(21) Application number: 03795437.7
(22) Date of filing: 12.09.2003
(51) Int. Cl.: H01L 31/08, H01L 31/042, H01M 14/00

(54) **PHOTOELECTRIC CONVERSION ELEMENT, PROCESS FOR PRODUCING THE SAME, LIGHT SENSOR AND SOLAR CELL**

(30) Priority: 13.09.2002 JP 2002067509
(71) Applicant: Sony Corporation, Tokyo 141-0001 (JP); Sony International (Europe) GmbH, 10785 Berlin (DE)
(72) Inventor: ENOMOTO, Masashi, c/o SONY CORPORATION, Shinagawa-ku, Tokyo 141-0001 (JP); VOSSMEYER, Tobias, SONY INT. (EUROPE) G.M.B.H., 70327 Stuttgart (DE)
(74) Representative: Nicholls, Michael John
(86) International application number: PCT/JP2003/011741
(87) International publication number: WO 2004/025738

(57) **Abstract**

An optical/ electrical conversion element used for a photosensor or a solar battery. An optical/ electrical conversion layer, composed of an assembly of a light-absorbing dendrimer structure (1), operating as an electron donor, and fine metal particles (2), operating as an electron receptor, are self-collectively formed by imparting chemical affinity to the dendrimer structure and to the fine metal particles. With the present optical/ electrical conversion element, in which the light-absorbing substance has a dendrimer structure, the electrons, excited on light absorption, migrate over a long distance via molecular chain to get to the fine metal particles (2) operating as an electron receptor. The electrons are routed quickly to outside as current via contact among the fine metal particles and/or between the fine metal particles and an electrode.

## Description

### Technical Field

This invention relaters to an optical/ electrical conversion element and a method of manufacturing the same, and a photosensor and a solar battery.

This invention claims priority of Japanese Patent Application 2002-267509, filed on September 3, 2002, the entirety of which is incorporated by reference herein.

### Background Art

The optical/ electrical conversion element forms an essential portion of a photosensor or a solar battery. As a photosensor, provided with an optical/ electrical conversion element, a semiconductor photosensor, employing inorganic semiconductor materials, such as silicon Si or germanium Ge, is known most extensively. If, in such semiconductor materials, photons having an energy larger than the band gap energy of the semiconductor, are absorbed, electrons in the valence band are excited into a conduction band, while positive holes are generated in the valence band. The semiconductor photosensor detects changes in the concentration of the charge carriers, attendant on light absorption, as changes in electrical characteristics, such as changes in electrical resistance.

The semiconductor photosensor unexceptionally responds to photons exhibiting the energy larger than the band gasp energy. For imparting selectivity of responding only to the light of a specified wavelength, auxiliary means, such as optical filters, are needed.

Such a photosensor, formed of an organic material, such as organic dyes, has also been known as being able to impart selectivity to light of a specified wavelength to the sensor itself. For example, an optical/ electrical conversion element, employing an organic thin film, has so far been developed for application to e.g. a photosensor, because it can be formed by vapor deposition or coating of organic molecules on a substrate and, as a principle, a large output voltage may be expected to be produced.

However, the organic thin film is difficult to deposit, so that it is difficult to produce a sensor, while the sensor produced is poor in sensitivity. Moreover, since the dyes are present in proximity to one another, in such film, there is raised such a problem that interactions among the dye particles give rise to quenching to render it impossible to make efficacious use of incident photons. There is also raised another problem that large current cannot be taken out because of the large internal resistance of the organic thin film.

The solar battery is a sort of the optical/ electrical conversion element for converting the light energy into the electrical energy. The solar battery has stirred up notice as an energy source to take the place of fossil fuel. There are currently known a solar battery exploiting the pn-junction of a semiconductor, and a dye sensitized solar battery, exploiting the photosensitizing action of dyes absorbed by a semiconductor layer, such as titanium oxide TiO₂.

The conventional solar batteries leave much to be desired in connection with the high production cost and with poor optical/ electrical conversion efficiency.

For realizing efficacious operations of the optical/ electrical conversion element, it is crucial how efficiently the electrons and cations or positive holes, yielded on energy absorption, are separated efficiently, and how promptly the charge carriers, thus separated, are taken out to outside as current.

One of the substances, currently stirring up notice, from this perspective, is a high molecular material having a dendrimer structure. For example, if, with dendrimer porphyrin, having a porphyrin structure at a core (center portion) and including an ionic functional group, such as carboxylate or ammonium, on an outer surface of the dendronic site, electron receiving molecules, such as viologen, are captured on the outer surface of the dendrimer porphyrin, electron migration over a long distance occurs from the core to the electron receptor through the dendronic site, on excitation of the porphyrin site of the core with light, thus setting up the state of charge separation. This state of the charge separation lasts long (R. Sakamoto et al., J. Am. Chem. Soc. (1996), 118,3978).

A report has also been made on exchanging the light excitation energy between dendrimers, with a spherically-shaped dendrimer, operating as a light excitation energy donor, having a cationic surface, into the core of which zinc porphyrin has been introduced, and with a spherically-shaped dendrimer, operating as a light excitation energy donor, having an anionic surface, into the core of which free base porphyrin has been introduced, (N. Tomioka et al., Angew. Chem. Int. Ed. (1998), 37, 1531-1534, Takuzou Aida, 'Chenistry and Industry' (1999), 52,955-958).

Although many reports were made in connection with causing long-distance electron migration or movement of the light excitation energy via molecular chains, there are only few reports made on successfully taking out the electrons or the energy as electric current to outside, while the current values thus taken out are not satisfactory (H. Imahori et al., J. Phys. Chem. B(2000), 104, 1253-1260).

### Disclosure of the Invention

It is an object of the present invention to provide an optical/ electrical conversion element, a method of manufacturing the same, a photosensor and a solar battery, by means of which the above-depicted problems of the prior art may be resolved.

For accomplishing the above object, the present invention provides a novel optical/ electrical conversion element comprising an optical/ electrical conversion layer formed by an assembly of a light-absorbing dendrimer structure operating as an electron donor and fine metal particles operating as an electron receptor, an optical sensor, and a solar battery.

With the photosensor and the solar battery, according to the present invention, the site of the dendrimer exhibiting light absorbing properties, such as a core, is excited with light. From this light-excited core, electrons migrate to outside the dendrimer through an electron chain in the dendronic site, until the electron get to the fine metal particles operating as an electron receptor.

That is, since the light absorbing substance has the dendrimer structure, the electrons, charge-separated on light absorption, may get to the fine metal particles operating as a current collector.

Since the light absorbing site is spaced apart from the fine metal particles by the dendronic site, electron migration in the reverse direction may be suppressed to protract the duration of the charge separated state. The result is that self quenching by the fine metal particles may be suppressed to minimize the risk of thermal deactivation of the charge separated state.

Moreover, since the sites exhibiting light absorption are separated from one another by the dendronic sites, there is no risk of quenching otherwise caused by interaction between the light absorbing substances.

In addition, since the fine metal particles operate as an electron acceptor, electrons are promptly routed to outside as current through contact among the fine metal particles themselves and/or through contact between the fine metal particles and/or the electrode. The light absorption by the light absorbing substance is augmented by the reinforcing action by surface plasmon by the fine metal particles, thus promoting charge separation.

Thus, with the present invention, it is possible to prepare an optical/ electrical conversion element of high sensitivity, high output and low internal resistance.

Moreover, with the present invention, it is possible to prepare a sensor, selectively responding only to light of a specified wavelength, without an optical filter, by suitably selecting the light absorbing substance.

In case the optical/ electrical conversion element is used as a charge separating layer of a solar battery, the semiconductor electrode, used in a conventional dye sensitized solar battery, is not needed, thus achieving a solar battery of a flexible shape. The dendrimer/ metal nano particle composite film is a porous film and may be contacted over a wide area with the electrolyte, thus providing a high efficiency cell.

With the present invention, the dendrimer structure preferably contains e.g. disulfide groups, capable of taking part in the bonding with metal, such as disulfide groups, and is surface-bonded to the fine metal particles.

The dendrimer structure preferably has molecules of groups of atoms exhibiting light absorption properties, such as a porphyrin structure or a phthalocyanine structure.

The fine metal particles are preferably of at least one metal selected from the group consisting of gold, platinum, palladium and silver, and of a nano-order particle size, in particular a particle size not larger than 10 nm.

According to the present invention, the optical/ electrical conversion layer and the electrolyte layer are preferably stacked together between a pair of electrode layers.

According to the present invention, the dendrimer structure and the fine metal particles are collected together to form the optical/ electrical conversion layer. A step of depositing the fine metal particles on an electrode layer and a step of depositing the dendrimer structure are preferably carried out sequentially at least once.

Preferably, a step of depositing the fine metal particles and the dendrimer structure is carried out after introducing functional groups that may be bonded to the fine metal particles on the surface of said substrate.

According to the present invention, in which the optical/ electrical conversion layer is formed by self-collection of the dendrimer structure and the fine metal particles, the optical/ electrical conversion element may be prepared readily, thus facilitating the preparation of the optical/ electrical conversion element and the control of the film structure or the layered structure.

Other objects and advantages of the present invention will become more apparent from the following description of the preferred embodiment thereof especially when read in conjunction with the drawings.

### Brief Description of the Drawings

Figs.1A to 1C are schematic cross-sectional views showing major portions of an optical/ electrical conversion layer according to the present invention.
Figs.2 and 3 are reaction flow diagrams showing the process of synthesis of dendrimer porphyrin.
Fig.4 is a chromatogram by recycle GPC of a vitreous solid.
Fig.5 depicts a NMR spectrum by two-dimensional 1H-1H COSY measurement indicating that he vitreous solid is dendrimer porphyrin.
Fig.6 depicts a NMR spectrum by two-dimensional 1H-1H COSY measurement indicating that the vitreous solid is dendrimer porphyrin (enlarged view of a 6.7 to 8.3 ppm area).
Fig.7 depicts a ultraviolet visible light absorption spectrogram testifying to the presence of the porphyrin structure in the vitreous solid.
Fig.8 depicts an ultraviolet visible light absorption spectrogram indicating the light absorption spectrum of an optical/ electrical conversion layer from one number of times of layering to another.
Fig.9A is a schematic plan view of a comb-type electrode used in a photosensor according to the present invention, and Fig.9B is a schematic perspective view thereof.
Fig.10 is a schematic cross-sectional view showing a photoelectric battery according to the present invention.

### Best Mode for Carrying out the Invention

Referring to the drawings, an optical/ electrical conversion element, a method of manufacturing the same, a photosensor and a solar battery, according to the present invention, are specifically explained.

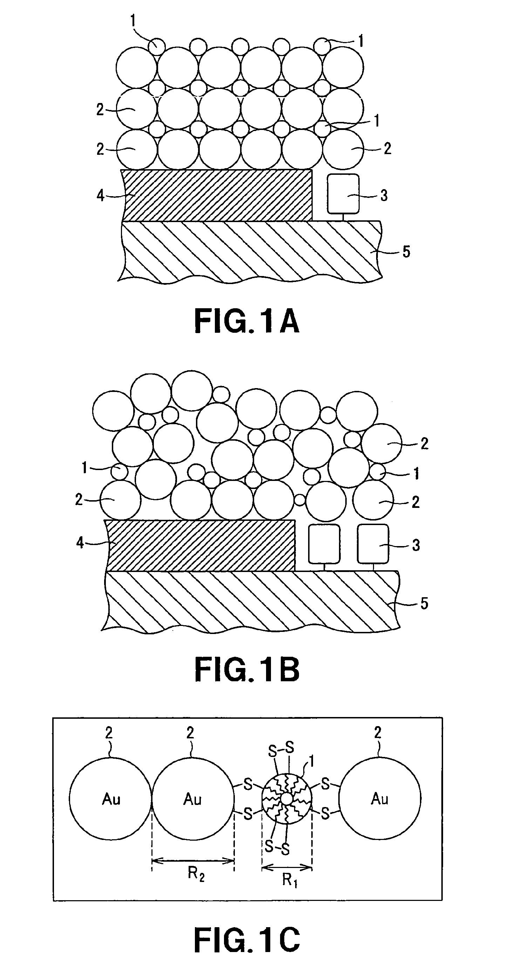

Figs.1A and 1B depict schematic cross-sectional views showing essential portions of an optical/ electrical conversion layer and specifically showing the structure of an assembly of a light absorbing dendrimer structure 1 and fine metal particles 2 in the vicinity of an electrode.

Fig.1A shows a state in which layers of the fine metal particles 2 and layers of the dendrimer structure 1 are stacked together in a regular pattern, for example, a state in which a layer of the fine metal particles 2, a layer of the dendrimer structure 1 and another layer of the fine metal particles 2 are arranged in the first, second and third layers, respectively. Fig.1B shows a state in which the array of the layers of the fine metal particles 2 and layers of the dendrimer structure 1 are disturbed such that a larger number of gaps are formed between neighboring particles. Which of these states is formed depends, for example, on the difference in size between the dendrimer structure 1 and the fine metal particles 2, chemical structure or the assembly forming method.

If, in accordance with the manufacturing method , as later explained, such an assembly is prepared which is composed of the dendrimer structure 1, as porphyrin (5) obtained on esterifying, with thiocto acid, the hydroxyl group of meso-tetrakis (3, 5-bis (3',5'- dihydroxystyryl) phenyl) porphyrin (4), and of the fine metal particles 2, as gold nano-particles, it may be supposed that the assembly is of a structure shown in Fig.1B, because the particle size R₁ of the dendrimer structure 1 is approximately 2 nm and the particle size R₂ of the fine metal particles 2 is approximately 4 nm, as shown enlarged in Fig.1C.

Since the thiocto acid contains a disulfide group, exhibiting chemical affinity with fine gold particles, there is formed a linkage between the dendrimer structure 1 and the fine metal particles 2, as shown enlarged in Fig.1C.

It is crucial for the dendrimer structure 1 and the fine metal particles 2 to exhibit chemical affinity with each other and, as a result, the assembly shown in Figs.1A and 1B has the following essentially crucial structural features.

The first feature is that the dendrimer structure 1 is surrounded by the fine metal particles 2 to provide for facilitated electron migration, with the dendrimer structure 1 acting as an electron donor and with the fine metal particles 2 acting as an electron receptor.

The second feature is that the fine metal particles 2, slightly coarser than the dendrimer structure 1, contact with one another, such as to form an electron flow path through contact of the fine metal particles 2 with one another and contact between the fine metal particles 2 and a metal electrode 4.

Hence, on light absorption by the dendrimer structure 1, the excited electrons are routed via molecular chain to the fine metal particles 2, operating as an electron receptor, and thence routed promptly to outside as current through contact between the fine metal particles 2 themselves and contact between the fine metal particles 2 and a metal electrode 4.

Consequently, there is no risk quenching otherwise caused by thermal deactivation of the state of charge separation or thorough interaction between the light absorbing substances.

Moreover, light absorption by the dye is augmented by the reinforcing action by surface plasmon by the fine metal particles 2, thus promoting charge separation. The light utilization efficiency is high because light incident on the optical/electrical conversion element proceeds within the optical/ electrical conversion layer, as the light is reflected by the fine metal particles 2, until the light is absorbed by the dendrimer structure 1.

Meanwhile, in case the fine metal particles 2 contact with a substrate 5 for the metal electrode 4, such as a glass substrate, the substrate surface is preferably pre-processed by a substance 3 exhibiting affinity to both the fine metal particles 2 and the substrate 4, as shown in Figs.1A and 1B. For example, if the fine metal particles 2 are fine gold particles, and the substrate 5 is a glass substrate, the glass substrate is heated with a solution of 3-aminpropyl dimethoxysilane to introduce amino groups onto the glass substrate.

The present invention is now explained with reference to Examples.

### Example 1

In the following, synthesis of dendrimer porphyrin and preparation of a composite film of a dendrimer porphyrin/ metal nano particles are explained in this order.

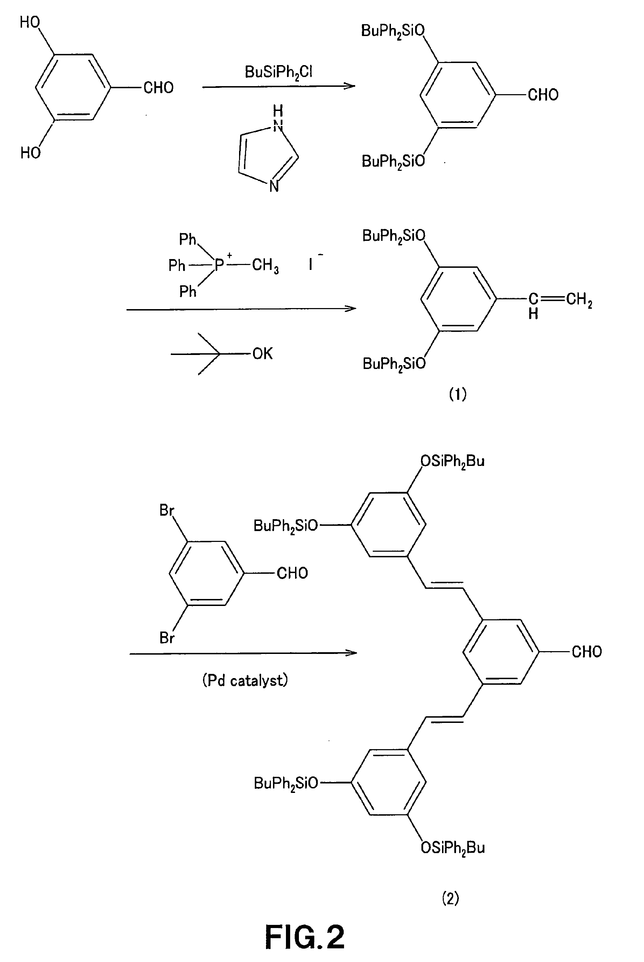

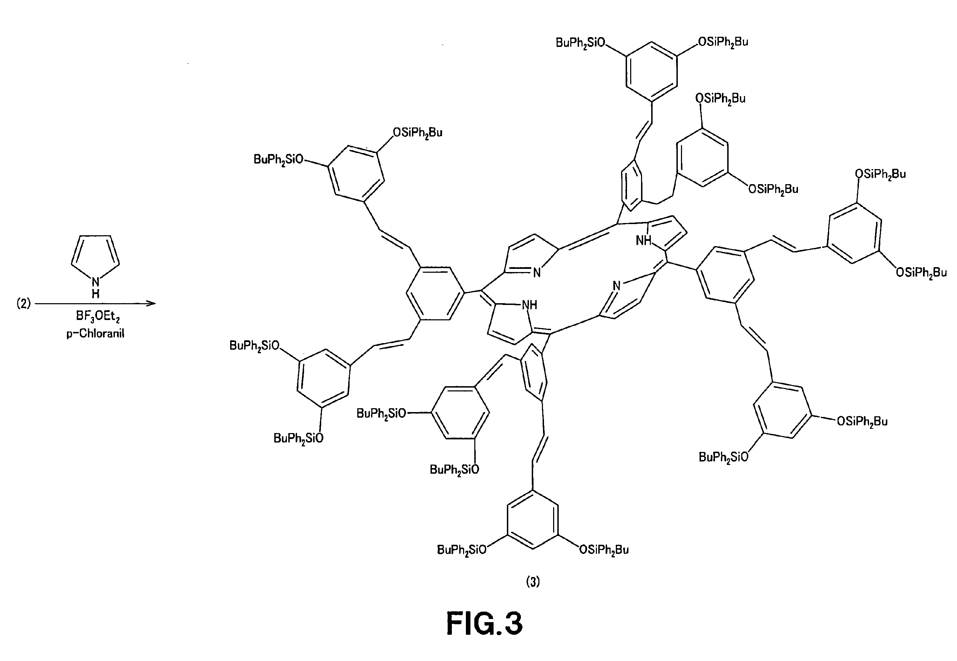

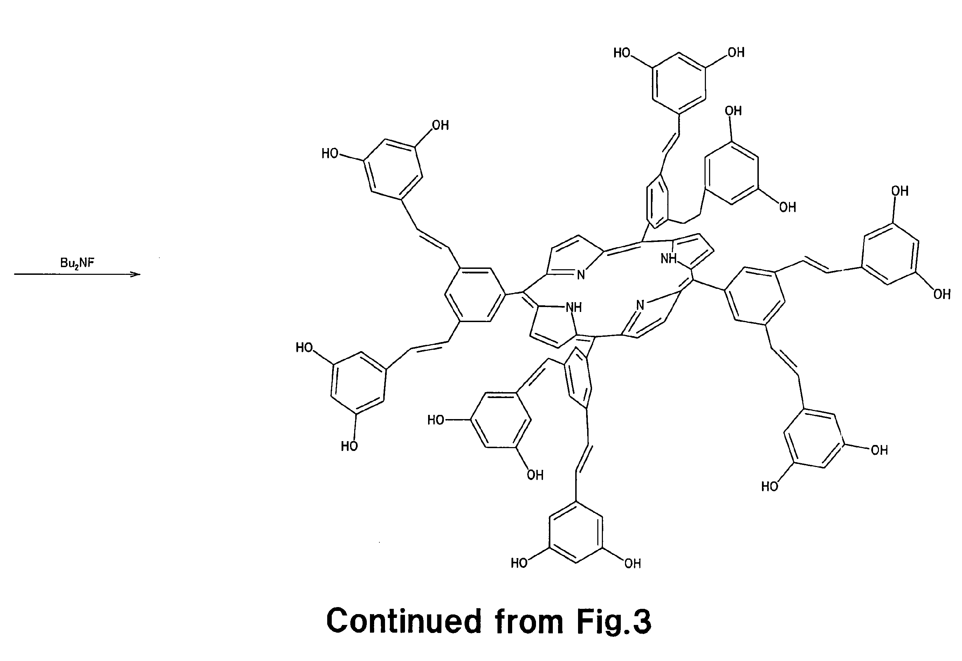

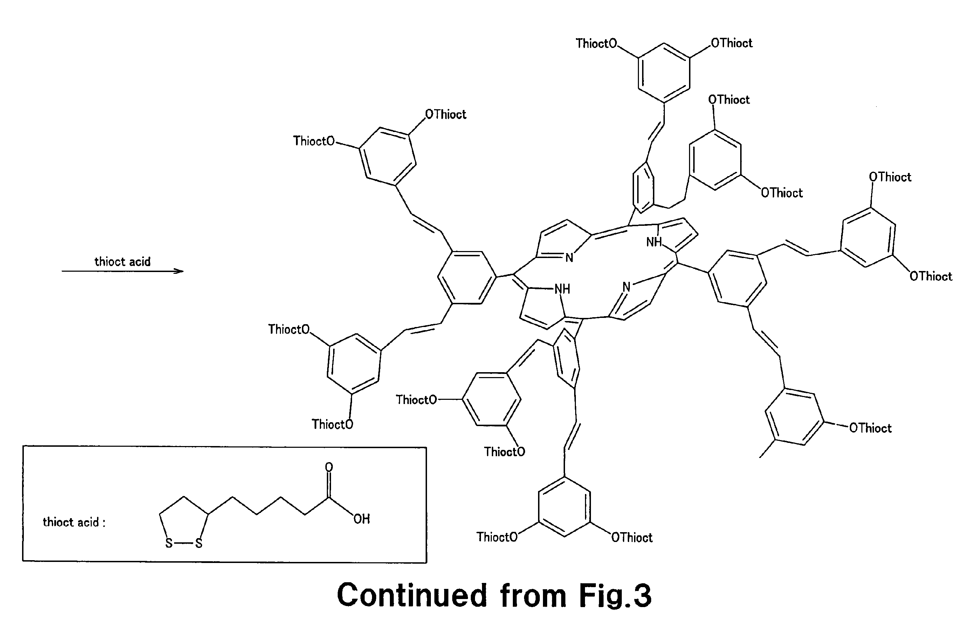

First, dendrimer porphyrin is synthesized by steps 1 to 5. Figs.2 and 3 depict reaction flow diagrams for synthesis.

### <Step 1 Synthesis and Purification of 3,5-bis(butyldiphenylsiloxi) styrene (1) by the Wittig reaction>

3,5- dihydroxybenzaldehyde and 2 equivalents of butylchlorodiphenylsilane CH3CH2CH2CH2SiCl(C6H5)2 are reacted together in dried methylene chloride, in the presence of an excess quantity of imidazole, to yield 3,5-bis(butyldiphenylsiloxi) benzaldehyde quantitatively at an yield approximately of 100%.

A benzaldehyde derivative (18.87 g, 29.58 mmol) was dissolved in 50 mL of dried tetrahydrofuran in an argon atmosphere. This solution was supplied dropwise to a pre-reacted solution of methyl iodide triphenyl phosphonium (CH3)(C6H5)3PI and potassium tert-butoxide in an argon atmosphere in a double-necked flask of 300 mL capacity, fitted with three way cocks and a rubber septum. After agitation for 90 minutes at room temperature, the solvent was distilled off, and the resulting mass was extracted with hexane and purified with silica gel column chromatography to yied 3,5-bis(butyldiphenylsiloxi) styrene (1) (15.95 g) with a yield of 88%.

### <Step 2 >

### < Step 1 Synthesis and Purification of 3,5-bis(3',5'-bis(butyldiphenylsiloxy) styryl) benzaldsehyde (2) by the Heck reaction >

By reacting palladium acetate (II) (0.90 g, 4.0 mmol) and tris (o-tolyl) phosphine (1.60 g, 5.26 mmol) in 100 mL of dry toluene in an argon atmosphere to yield a targeted palladium catalyst as yellow-colored needle-like crystals.

### (Heck reaction)

In a one-neck cylindrically-shaped flask of 500 mL capacity, provided with three way cocks, dried in vacuo and from which argon was substituted for residual air, 3,5- dibromobenzaldehyde (1.06g, 4.0 mmol), 3,5- bis (butyldiphenylsiloxy) styrene (1) (6.13g, 10.0 mmol), sodium carbonate (1.06 g, 10.0 mmol), 8.1 mg of the above palladium catalyst, 2,6- di-tert-butyl-p-cresol (0.44 g, 2.0 mmol) and 5.0 mL of anhydrous N,N- dimethyl acetoamide, were charged, and argon substitution was repeated three times. After reaction at 130ºC for 24 hours, the solvent was extracted with 250 mL of 1.5M hydrochloric acid/ 250 mL of ether.

The ether layer was washed with de-ionized water. The resulting mass was dried with anhydrous sodium sulfate, filtered and freed of a solvent to yield 8g of a highly viscid product. This product was isolated by silica gel column chromatography, using a development solution of hexane and dichloromethane (volumetric fraction of hexane: 30%), to yield 1.04 g of the above aldehyde as a fourth fraction. Since this fraction still contained a by-product in which only one of two bromine atoms of 3,5- dibromobenzaldehyde has been substituted, the faction was purfied by fractionating gel permeation chromatography (GPC) to yield 0.75 g of pure 3,5-bis(3',5'-bis(butyldiphenylsiloxy) styryl) benzaldsehyde (2), with a yield of 14%.

### <Step 3 Synthesis and Purification of meso-tetrakis 3,5-bis (3',5'-bis(butyldiphenylsiloxy) styryl) phenyl) porphyrin (3)>

In a double-necked egg-plant-shaped flask, with a capacity of 100 mL, fitted with three way cocks, thoroughly dried and which was freed of residual air with argon, 3,5-bis (butyldiphenylsiloxy) styryl benzaldehyde (2) (0.75g, 0.565mmol) was charged. After substitution with argon, pyrrole (0.039 mL, 0.565mmol) and 56.5 mL of de-aerated chloroform, as a solvent, were added to dissolve the benzaldehyde derivative (2). To the reaction system was added boron trifluoide diethyl etherate (diethylether- boron trifluoride) BF30 (C2H5)2 (26.4 mg) and the resulting mass was reacted at room temperature for one hour. To the reaction system was further added p-chloroanyl (tetrachloro-p-benzoquinone) (104.2 mg) and reaction was continued for further one hour.

After the reaction, the product was isolated by silica gel column chromatography, using chloroform as development solution, to fractionate a first fraction exhibiting the phosphor light characteristic of porphyrin (0.67 g). This crude product was purified by fractionating GPC to recover porphyrin (3) (0.58g) with the assumption that the fraction which gives the maximum molecular weight is the targeted prophyrin.

### <Step 4 Synthesis and Purification of meso-tetrakis (3, 5-bis (3',5'-dihydroxystyryl) phenyl) porphyrin (4)>

Into a 200 mL double-necked egg-plant-shaped flask, fitted with three way cocks, meso-tetrakis (3, 5-bis (3',5'-butyl diphenyl siloxy) styryl) phenyl) porphyrin (3) and tetrabutylammonium fluoride trihydrate (0.59g, 0.11 mmol) were charged and argon was substituted for air. To the resulting reaction system was added 30 mL of dried tetrahydrofuran and the reaction was continued for ten hours.

Fine black crystals produced were filtered and washed thoroughly, sequentially using ether, 0.1M ether solution of hydrogen chloride and 50 mL of de-ionized water. The resulting mass was dissolved in 50 mL of methanol. After filtration, the solvent was distilled off and the resulting mass was dried under reduced pressure to yield 134.6 mg of meso-tetrakis (3, 5-bis (3',5'-dihydroxystyryl) phenyl) porphyrin (4) (yield: 76%).

### < Step 5 Synthesis and Purification of dendrimer porphyrin (5), having a disulfide group introduced therein, by an esterifying reaction of meso-tetrakis (3, 5-bis (3',5'-dihydroxystyryl) phenyl) porphyrin (4) with thioocto acid>

Into a 200 mL double-necked egg-plant-shaped flask, fitted with three way cocks, meso-tetrakis 3, 5-bis (3',5'-dihydroxystyryl) phenyl) porphyrin (4) (134.6 mg, 0.078 mmol) was charged, and subjected to drying in vacuo for two hours. Under an argon stream, thiocto acid (alias name: ribo-acid) (284.2 mg, 1.38 mmol), dicyclohexyl carbodiimide (DCC) (489.9 mg, 2.37 mmol), 4-dimethyl aminopyridine (DMAP) (53.7 mg, 0.44 mmol) were added quickly. After evacuation and substitution of argon for residual air, a mixed solvent of 22 mL of dry toluene and 10 mL of dry tetrahydrofurane was added to the reaction system followed by agitation at room temperature.

In three days, a sample was taken and analyzed with silica gel thin-layer chromatography (LTC). Since a small amount of the starting material was found in addition to low polarity porphyrin, supposed to be a desired product,20 mL of dry tetrahydrofurane, in which were dissolved thiocto acid (56.8 mg), DCC (98.0 mg) and DMAP (10.7 mg), were added to the reaction system, and the reaction was continued for further three days.

The reaction product was added dropwise to methanol in an argon atmosphere to precipitate a porphyrin component. This operation of dissolution in tetrahydrofuran and precipitate formation in methanol was repeated to purify the product. After drying under reduced pressure, dendrimer porphyrin (5), having disulfide groups introduced therein, as red-purple vitreous solid, was produced (yield: 87%).

The GPC analysis of the vitreous solid indicated the presence of an extremely small amount of the high molecular component (supposedly a dimmer). However, a chromatogram with a neat single peak was produced, indicating that the octo acid groups have fully been introduced.

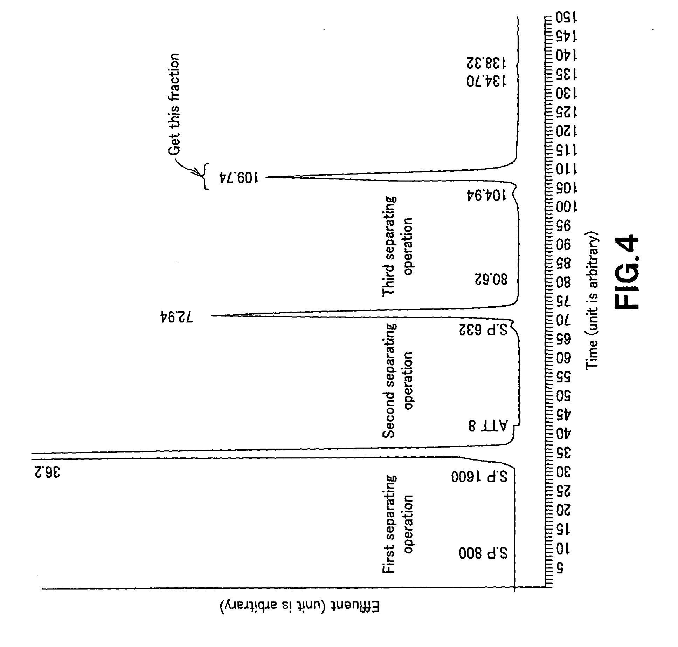

Fig.4 depicts a chromatogram in case the fractionating GPC is caused to act as recycle GPC and effluent components after the isolating operation is returned to a sample inlet in order to effect repeated separating operations for the same sample. In the crude product, there is contained an impurity which is effluent at a time slightly earlier than dendrimer porphyrin (5). Although the separation of this impurity and dendrimer porphyrin (5) is insufficient with the first isolating operation, it is improved with each repetition of the isolating operations, such that the two are completely separated from each other with the third separating operation. Here, the dendrimer porphyrin (5), effluent with a delay with respect to the impurity, was fractionated with the third separating operation. The quantity of the impurity is small, indicating that the compound (dendrimer porphyrin (5)) could be synthesized with high purity.

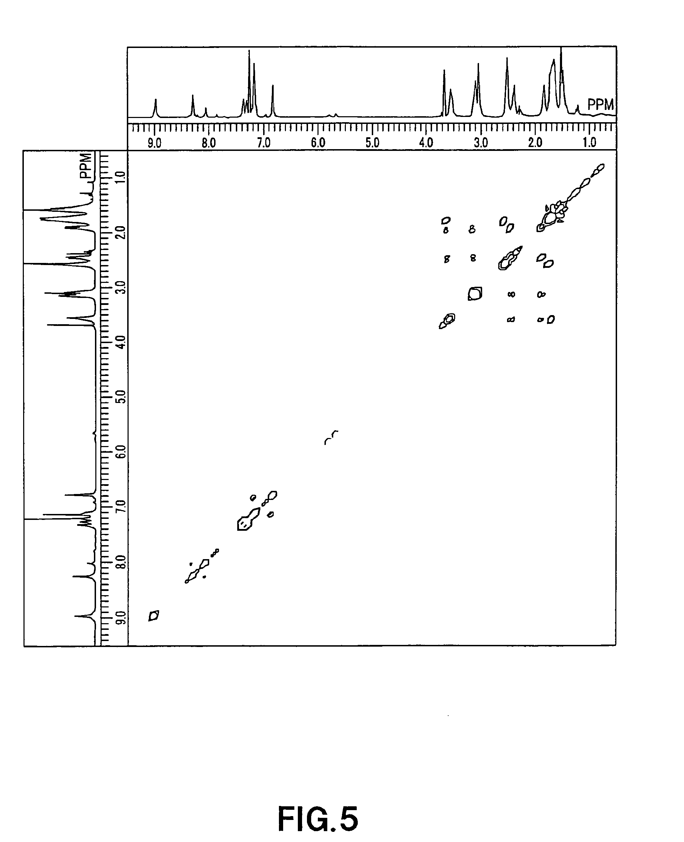

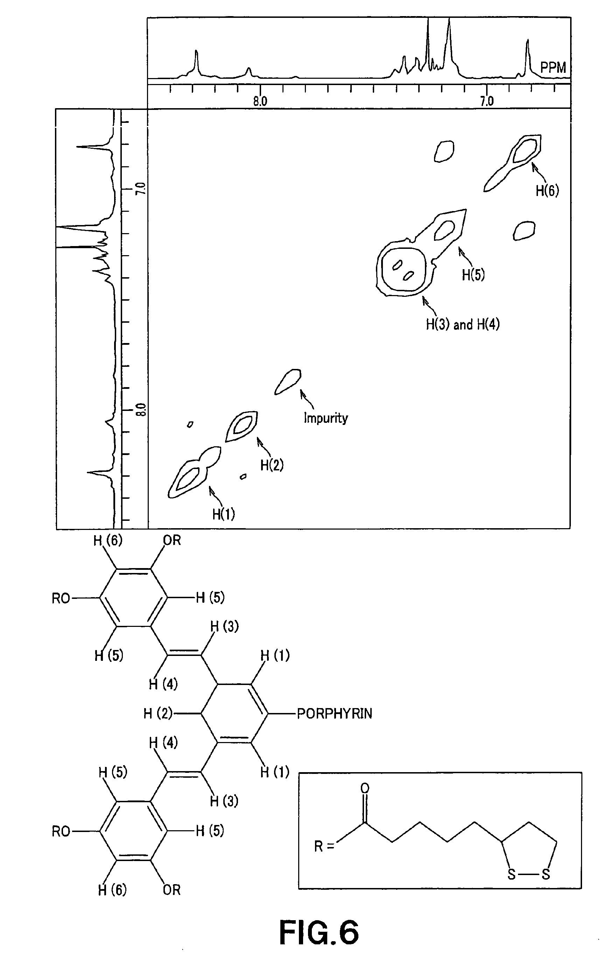

The structure of dendrimer porphyrin (5) could be confirmed from the spectrum of the vitreous solid by the 1H NMR spectroscopic method (normal one-dimensional measurement and 1H-1H COSY (correlation spectroscopy) measurement (see Figs.5 and 6). Fig.5 shows the absorption spectrum in its entirety. Fig.5 shows, to an enlarged scale, the absorption spectrum for 6.7 to 8.3 ppm of hydrogen atoms H(1) to H(6), contained in the dendronic site, particularly crucial in identifying the dendrimer- porphyrin structure.

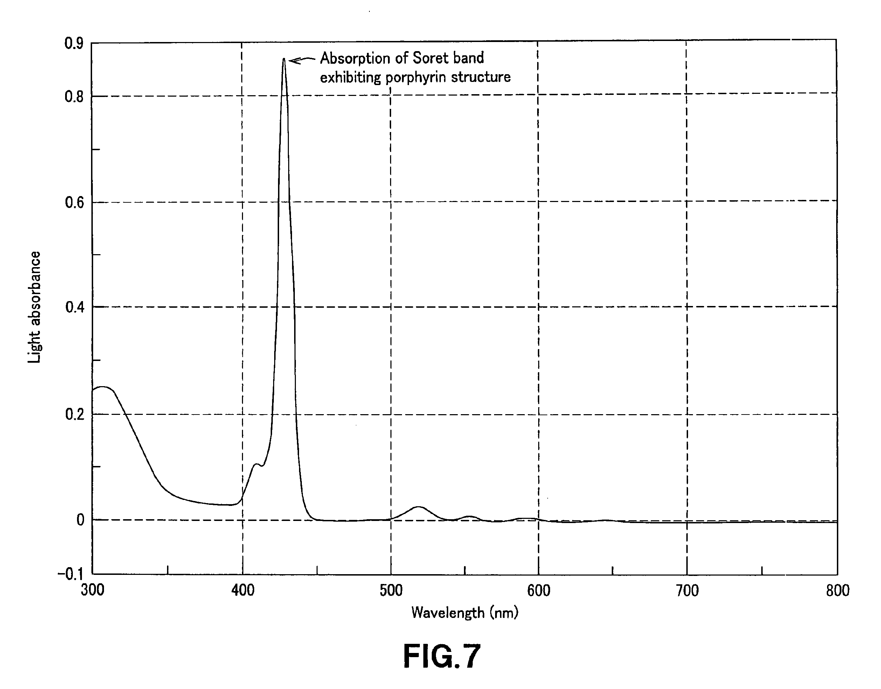

The ultraviolet visible light absorption spectrum of this vitreous solid was measured to ascertain the absorption of the Soret band, indicating the presence of the porphyrin structure (Fig.7).

The preparation of a dendrimer- porphyrin/ metal nano-particle composite film is now explained.

### <Step 6 Preparation of nano-particles of gold>

A colloidal solution of nano-particles of gold, stabilized by dedecylamine, was prepared in accordance with a report by Leff et al. (D.V. Leff et al., Langmuir (1996), 12,4723-30).

160 mg of gold chloride (III) AuCl3 were dissolved in 20 mL of distilled water. 160 mg of gold chloride (III) AuCl3 were dissolved in 20 mL of distilled water and a solution in 20 mL of toluene of 639 mg of tetraoctyl ammonium bromide was added to the AuCl aqueous solution, as the reaction system was agitated vigorously. The agitation was continued until the toluene layer turned to orange color and the water layer was colorless. To the resulting solution was added a solution in 20 mL of toluene of 1178 mg of dodecylamine. It was seen that the toluene layer changed from the orange color to a red color. An aqueous solution in 15 mL of water of 221 mg of sodium tetrahydroborate (sodium boron hydride) NaBH4 was added to the above solution, as the reaction system was agitated vigorously. The toluene layer immediately turned into a deep purple color.

After agitation overnight at room temperature, the toluene layer was separated and 40 mL of ethanol were added to the remaining reaction system. The resulting mixed solution was kept in a still state overnight in a freezer kept at -18ºC to form precipitates, which were then filtered through a nylon filter having a pore diameter of 0.45 µm and were again dissolved in 17.5 mL of toluene.

The resulting solution was subjected to repeated fractionation/re-precipitation. The operational sequence of the fractionation/ re-precipitation is
1. addition of 40 mL of ethanol;
2. keeping overnight in a freezer kept at -18ºC; and
3. separation of the precipitate by centrifugation.

By repetition of the above operations, the precipitates were divided into four fractions, and a fraction 2, having an optimum particle size, was used for preparing a sensor. By measurement of the fraction 2 with a TEM (transmission electron microscope), it was found that the nano particles of gold were crystals with an average particle size of 3.9 nm (±1.2 nm).

### <Step 7 Preparation and characterization of dendrimer porphyrin/ metal nano particle composite film>

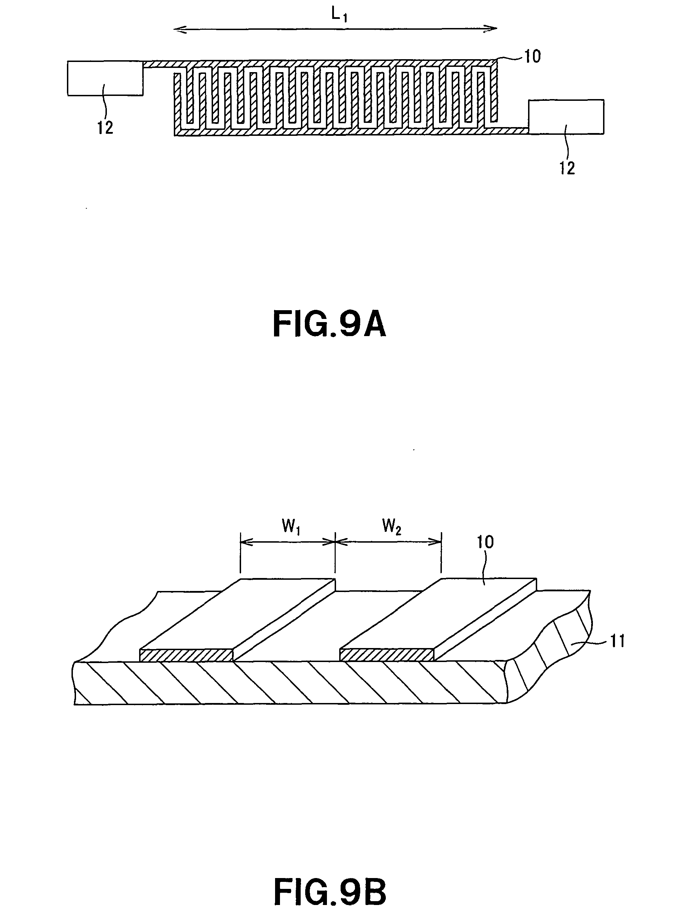

The composite film was layered on a glass substrate 11 of BK7 glass (borosilicate glass #7), carrying a comb-shaped electrode 10 of Figs.9A and 9B, patterned thereon.

As for the electrode structure, a gold layer, 95 nm in thickness, is deposited on a Ti absorption layer, 5 nm in thickness, on a glass substrate 11, and an overlap L₁ of a length of 1800 µm is provided, with an electrode width W1 of 10µm and a gap W2 of 10µm. Before preparing a composite film, the glass substrate was washed with acetone and 2-propanol and further processed with an oxygen plasma (30W, 0.24 mbar for four minutes). The glass substrate, thus washed, was immersed in a solution in 5 mL of toluene of 50µL of 3- aminopropyl dimethylethoxy silane, and was heated for 30 minutes at 60ºC in order to introduce amino groups onto the glass substrate.

This substrate was washed with toluene and immersed for 15 minutes in the solution of nano particles of gold prepared in the <step 6>. As for the concentration of the solution of fine gold particles, the absorbance of light with the wavelength of 514 nm was 0.4. The substrate was then immersed in a solution in 5 mL of toluene of 10 mg of dendrimer porphyrin (5) for 15 minutes.

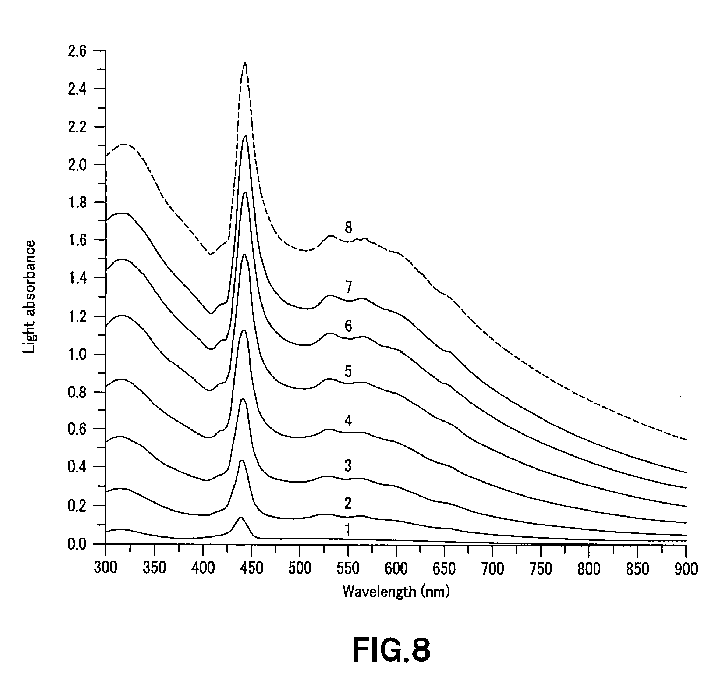

The operations of alternately immersing the glass substrate in the above two solutions in the above sequence were repeated 14 times. The cycle-based degree of layering was checked by measuring the absorbance of light with a wavelength of 514 nm which is the plasmon absorption of the fine gold particles (Fig.8).

By measuring the tapping mode of the AFM (atomic force microscope), it was seen that a porous film of the pore diameter of approximately 60 nm was formed. The film resistance was 1.6 MΩ. The tapping mode is among the AFM measurement methods and consists in oscillating a cantilever fitted with a search needle at a frequency in the vicinity of the resonant frequency of a piezo element (ca. 50 to 500 kHz) and in scanning the sample surface as it is touched lightly (tapped) and intermittently to measure the surface with a minimum damage to the surface being measured.

Since the dendrimer structure 1 and the fine metal particles 2 exhibit chemical affinity to each other, a thin film can be formed self-collectively by alternately carrying out a step of depositing the fine metal particles and a step of depositing the dendrimer structure on the electrode layer as described above.

By exploiting self-systematization of the dendrimer structure 1 and the fine metal particles 2, it is readily possible to prepare the device and to control film thickness or the layered structure. By the self-systematization, it is readily possible to prepare a film in which the light absorbing substances are three-dimensionally systematized and which exhibits sufficient light absorbing characteristics.

### Example 2

The function as the photosensor of the dendrimer porphyrin/ metal nano-particle composite film, formed on the above-mentioned comb-shaped electrode, was scrutinized.

As the minor current (ca. 20 nA) was caused to flow across the two electrodes, white light of a 150W xenone lamp was illuminated on the composite film. It was then seen that the resistance was decreased appreciably as a result of the light illumination. It may be conjectured that separation of electrical charges occurred across dendrimer porphyrin and fine particles of gold, with the electrical charges operating as the current carrier.

From an action spectrum in which monochromatic light was sorted by a monochrometer and changes in the current flowing as a result of light illumination were recorded, as the wavelength of the monochromatic light was changed, the photocurrent attendant on the absorption of the porphyrin complex was observed, thus demonstrating that the porphyrin dye operated properly.

From the foregoing, it may be seen that this dendrimer- porphyrin/ metal nano-particle composite film may be used efficaciously as a photosensor.

### Example 3

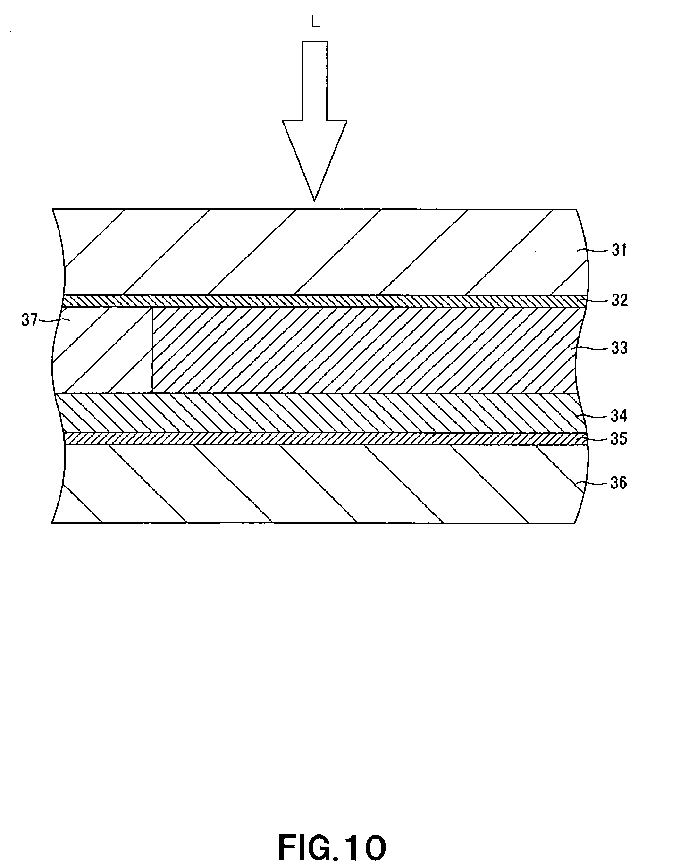

Fig.10 depicts a schematic cross-sectional view showing major portions of the photocell employing a dendrimer/ metal nano-particle composite film 34.

As in the above comb-shaped electrode, a gold layer 35, having a thickness of 95 nm, was layered on the entire surface of a Ti absorbing layer on a BK7 glass substrate 36. Prior to preparation of the composite film, the glass substrate 36 was washed with acetone and 2-propanol and further processed with oxygen plasma (30W, 0.24 mbar for four minutes).

The so washed glass substrate was immersed for 15 minutes in the solution of the nano particles of gold, prepared in the step 6. The concentration of the solution of the nano particles of gold was 0.4 in terms of absorbance of the light with a wavelength of 514 nm. The glass substrate was then immersed in a solution in 5 mL of toluene of 10 mg of dendrimer porphyrin for 15 minutes.

The above sequence of operations was repeated 14 times. A U-shaped spacer 37 (inner size: 20 mm×5mm), with a thickness of 0.3 mm, was placed on the glass substrate, and a glass substrate 31, having a meshed platinum electrode 32 patterned thereon, was placed on the U-shaped spacer and the resulting assembly was clinched tightly together to prepare a cell. A 0.1M sodium sulfate solution of methyl viologen (10 mM) was sealed into the cell as an electrolytic solution 33 in an argon atmosphere to prepare a photocell.

A silver- silver chloride electrode, dipped in a saturated aqueous solution of potassium chloride, as a reference electrode, was added to the so prepared photocell and three-electrode voltammetric measurement was carried out. As a monochromatic light beam L (6 mM), corresponding to absorption of the Soret band of dendrimer porphyrin, was illuminated, the potential of the gold electrode, with respect to the reference electrode, was swept from -200 mV to 700 mV. The photocurrent as high as 6 mA/cm² was observed for the bias voltage of -200 mV.

This current is appreciably higher than the value of 660 nA reported so far on the gold electrode (H. Imahori et al., J. Physics. Chem. B(2000), 104, 1253-1260) and suggests the usefulness of the present system.

In the present embodiment, no zinc ions are introduced into the porphyrin structure. The zinc ions may be introduced into the porphyrin structure by immersing the glass substrate in a methanol solution saturated with zinc acetate. It may be supposed that the conversion efficiency may be further improved by introducing zinc ions into the porphyrin structure.

In case the optical/ electrical conversion element of the present invention is used as a charge separating layer for the solar battery, the semiconductor electrode, used in the conventional dye sensitized solar battery, is not needed, so that the solar battery may be made more flexible in shape. Moreover, since the dendrimer/ metal nano-particle composite film 34 is a porous film, and a contact area with the electrode may be larger, so that a cell may be improved in efficiency.

The present invention is not limited to the embodiments described above with reference to the drawings and, as may be apparent to those skilled in the art, various changes, substitutions or the equivalents may be envisaged without departing from the scope of the invention as defined in the claims.

### Industrial Applicability

According to the present invention, in which the light absorbing substance has a dendrimer structure, the electrons, subjected to charge separation by light absorption, may reach the fine metal particles, operating as a current collector.

That is, site of the dendrimer, exhibiting light absorption, for example, the core, is excited with light. From this core, excited with light, the electrons traverse the electron chains of the dendronic site to migrate over a long distance to outside the dendrimer. The electrons may get to the fine metal particles operating as electron receptors.

Since a distance is provided between the site exhibiting light absorption by the dendronic site and the fine metal particles, reverse electron migration is suppressed to achieve long useful life of the charge separated state. It is thus possible to prevent self-quenching by the fine metal particles, so that there is only little risk of thermal deactivation of the state of charge separation.

Moreover, since the light absorbing sites are separated from one another by the dendronic site, there is only little risk of quenching otherwise caused by interactions between the light absorbing substances.

In addition, since the electron receptors are fine metal particles, the electrons are routed to outside quickly as current through contact of the fine metal particles with one another and/or through contact of the fine metal particles with the electrodes. On the other hand, light absorption by dye is augmented by the reinforcing action by surface plasmon of the fine metal particles 2, thus promoting charge separation.

Consequently, the optical/ electrical conversion element with a high sensitivity, a high output and a low inner resistance may be produced.

By proper selection of the light absorbing substance, a photosensor, selectively responding only to the light of a specified wavelength, may be prepared without employing an optical filter.

In case the optical/ electrical conversion element according to the present invention is used as a charge separating layer for a solar battery, no semiconductor substrate, used in a dye sensitized solar battery, is needed, and hence a solar battery may be made more flexible in shape. Moreover, since a contact area with the electrode may be larger, it is possible to prepare a cell improved in efficiency.

## Claims

**1.** An optical/ electrical conversion element comprising an optical/ electrical conversion layer formed by an assembly of
a light-absorbing dendrimer structure operating as an electron donor; and fine metal particles operating as an electron receptor.

**2.** The optical/ electrical conversion element according to claim 1 wherein said dendrimer structure is bonded to said fine metal particles on a surface.

**3.** The optical/ electrical conversion element according to claim 2 wherein said dendrimer structure includes a disulfide group taking part in said binding on a surface.

**4.** The optical/ electrical conversion element according to claim 1 wherein said dendrimer structure includes molecules of groups of atoms exhibiting light absorption properties.

**5.** The optical/ electrical conversion element according to claim 4 wherein said molecules of groups of atoms exhibiting light absorption properties comprise a porphyrin structure or a phthalocyanine structure.

**6.** The optical/ electrical conversion element according to claim 1 wherein said fine metal particles are of a nano-order particle size.

**7.** The optical/ electrical conversion element according to claim 1 wherein said fine metal particles are of at least one metal selected from the group consisting of gold, platinum, palladium and silver.

**8.** The optical/ electrical conversion element according to claim 1 wherein said optical/ electrical conversion layer and the electrolyte layer are layered between a pair of electrode layers.

**9.** A method for producing an optical/ electrical conversion element comprising an optical/ electrical conversion layer formed by an assembly of
a light-absorbing dendrimer structure operating as an electron donor; and fine metal particles operating as an electron receptor, comprising
forming the optical/ electrical conversion layer by collecting said dendrimer structure operating and said fine metal particles.

**10.** The method for producing an optical/ electrical conversion element according to claim 9 comprising
a step of depositing said fine metal particles on an electrode layer and a step of depositing said dendrimer structure are carried out sequentially at least once.

**11.** The method for producing an optical/ electrical conversion element according to claim 10 comprising
a step of depositing said fine metal particles and said dendrimer structure after introducing functional groups, that may be bonded to said fine metal particles, on the surface of said substrate.

**12.** The method for producing an optical/ electrical conversion element according to claim 9 wherein said dendrimer structure is bonded to said fine metal particles on the surface of the optical/ electrical conversion element.

**13.** The method for producing an optical/ electrical conversion element according to claim 9 wherein said dendrimer structure of the optical/ electrical conversion element includes a disulfide group taking part in the bonding on the surface thereof.

**14.** The method for producing an optical/ electrical conversion element according to claim 9 wherein said dendrimer structure of the optical/ electrical conversion element includes light-absorbing molecules or groups of atoms on the surface thereof.

**15.** The method for producing an optical/ electrical conversion element according to claim 14 wherein said light-absorbing molecules or groups of atoms of the optical/electrical conversion element include a porphyrin structure or a phthalocyanine structure.

**16.** The method for producing an optical/ electrical conversion element according to claim 9 wherein the fine metal particles of the optical/ electrical conversion element has a nano particle size.

**17.** The method for producing an optical/ electrical conversion element according to claim 9 wherein the fine metal particles of the optical/ electrical conversion element are fine metal particles of at least one metal selected from a group consisting of gold, platinum and palladium.

**18.** The method for producing an optical/ electrical conversion element according to claim 9 wherein the optical/ electrical conversion element is composed of a pair of electrode layers and a layered set of the optical/ electrical conversion layer and the electrolyte layer arranged therebetween.

**19.** An optical sensor employing, as a charge separating layer, an optical/ electrical conversion element composed of a set of a light absorbing dendrimer structure operating as an electron donor and fine metal particles operating as an electron receptor.

**20.** The optical sensor according to claim 19 wherein said dendrimer structure of the optical/ electrical conversion element is bonded to said fine metal particles on the surface thereof.

**21.** The optical sensor according to claim 19 wherein said dendrimer structure of the optical/ electrical conversion element has a disulfide group taking part in said bonding on the surface thereof.

**22.** The optical sensor according to claim 19 wherein said dendrimer structure of the optical/ electrical conversion element has molecules or a group of atoms exhibiting light absorbing properties.

**23.** The optical sensor according to claim 22 wherein said molecules or a group of atoms exhibiting light absorbing properties of the optical/ electrical conversion element are of a porphyrin structure or a phthalocyanine structure.

**24.** The optical sensor according to claim 19 wherein said fine metal particles of the optical/ electrical conversion element are of a nano particle size.

**25.** The optical sensor according to claim 19 wherein said fine metal particles of the optical/ electrical conversion element are fine particles of at least one metal selected from the group consisting of gold, platinum and palladium.

**26.** The optical sensor according to claim 9 wherein said dendrimer structure of the optical/ electrical conversion element includes a disulfide group taking part in the bonding on the surface thereof.

**26.** The optical sensor according to claim 19 wherein said optical/ electrical conversion element and the electrolyte layer are layered between a pair of electrode layers.

**27.** A solar battery comprising an optical/ electrical conversion element including an optical/ electrical conversion layer formed by an assembly of a light-absorbing dendrimer structure operating as an electron donor and fine metal particles operating as an electron receptor,

**28.** The solar battery according to claim 27 wherein said dendrimer structure of the optical/ electrical conversion element is bound to said fine metal particles on a surface.

**29.** The solar battery according to claim 27 wherein said dendrimer structure of the optical/ electrical conversion element includes a disulfide group taking part in said bonding on the surface thereof.

**30.** The solar battery according to claim 27 wherein said dendrimer structure of the optical/ electrical conversion element includes molecules of groups of atoms exhibiting light absorption properties.

**31.** The solar battery according to claim 27 wherein said molecules of groups of atoms exhibiting light absorption properties in the optical/ electrical conversion element comprise a porphyrin structure or a phthalocyanine structure.

**32.** The solar battery according to claim 27 wherein said fine metal particles of the optical/ electrical conversion element are of a nano-order particle size.

**33.** The solar battery according to claim 27 wherein said fine metal particles of the optical/ electrical conversion element are of at least one metal selected from the group consisting of gold, platinum, palladium and silver.

**34.** The solar battery according to claim 27 wherein said optical/ electrical conversion layer and the electrolyte layer of the optical/ electrical conversion element are layered between a pair of electrode layers.
